(19) Europäisches Patentamt / European Patent Office / Office européen des brevets

(11) **EP 4 383 994 A1**

(12) **EUROPEAN PATENT APPLICATION**
published in accordance with Art. 153(4) EPC

(43) Date of publication:
**12.06.2024 Bulletin 2024/24**

(21) Application number: **22853122.4**

(22) Date of filing: **03.08.2022**

(51) International Patent Classification (IPC):
**H10N 15/20** (2023.01)       **H02N 11/00** (2006.01)

(52) Cooperative Patent Classification (CPC):
**H02N 11/00**

(86) International application number:
**PCT/JP2022/029863**

(87) International publication number:
**WO 2023/013704 (09.02.2023 Gazette 2023/06)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **06.08.2021 JP 2021130340**

(71) Applicant: **NITTO DENKO CORPORATION
Ibaraki-shi
Osaka 567-8680 (JP)**

(72) Inventors:
• **TANAKA, Hirokazu**
  **Ibaraki-shi, Osaka 567-8680 (JP)**
• **NAKANISHI, Yosuke**
  **Ibaraki-shi, Osaka 567-8680 (JP)**
• **TSURUTA, Hijiri**
  **Ibaraki-shi, Osaka 567-8680 (JP)**

(74) Representative: **Müller-Boré & Partner
Patentanwälte PartG mbB
Friedenheimer Brücke 21
80639 München (DE)**

(54) **THERMOELECTRIC CONVERSION ELEMENT**

(57) A thermoelectric conversion element 1a includes a substrate 10 and magnetic bodies 21. The magnetic bodies 21 are disposed on the substrate 10 and have ferromagnetism or antiferromagnetism. The magnetic bodies 21 have an internal stress of 900 MPa or less.

FIG.1

**EP 4 383 994 A1**

**Description**

TECHNICAL FIELD

The present invention relates to a thermoelectric conversion element.

BACKGROUND ART

Thermoelectric conversion elements that utilize magnetothermoelectric effect have been known.

For instance, Patent Literature 1 describes a thermoelectric generation device utilizing anomalous Nernst effect. The anomalous Nernst effect is a phenomenon that a voltage is generated in a direction orthogonal to both the magnetization direction and a temperature gradient when a temperature difference is caused by a heat flow through a magnetic material. The thermoelectric generation device includes a substrate, a generator, and a connector. The substrate has at least a surface layer made of MgO. The generator includes thin wires disposed parallel to each other along a surface of the substrate. The respective thin wires are made of a ferromagnetic material and magnetized in the same direction. The connector includes thin wires each disposed between a pair of the thin wires of the generator and in parallel to each of the thin wires of the generator. Each thin wire of the connector electrically connects one end part of each thin wire of the generator and another end part of a thin wire adjacent to the thin wire of the connector at one side of the first-described thin wires.

CITATION LIST

Patent Literature

Patent Literature 1: JP 2014-072256 A

SUMMARY OF INVENTION

Technical Problem

In Patent Literature 1, the thin wires of the generator made of a ferromagnetic material are connected to each other in series by the connector. It is considered that this causes generation of a high electromotive force in the thermoelectric generation device. It is thought, on the other hand, that the overall functionality of the thermoelectric generation device may be impaired if a disconnection occurs due to a crack or any other causes at any point in the thin wires of the connector or a heater.

It is thought that, if a thermoelectric conversion element utilizing a magnetothermoelectric effect can be used in various environments, the value of thermoelectric conversion element can be further increased. On the other hand, according to Patent Literature 1, the durability of the thermoelectric generation device in certain environments has not been studied at all.

In view of these circumstances, the present invention provides a thermoelectric conversion element that utilizes a magnetothermoelectric effect, which is advantageous in exhibiting high durability in a high temperature and high humidity environment.

Solution to Problem

The present invention provides a thermoelectric conversion element including:

a substrate; and
a magnetic body disposed on the substrate and having ferromagnetism or antiferromagnetism,
wherein the magnetic body has an internal stress of 900 MPa or less.

Advantageous Effects of Invention

The above-described thermoelectric conversion element is advantageous in that it exhibits high durability in a high temperature and high humidity environment while utilizing the magnetothermoelectric effect.

BRIEF DESCRIPTION OF DRAWINGS

FIG. 1 is a perspective view showing an example of thermoelectric conversion element according to the present invention.
FIG. 2 is a cross-sectional view of the thermoelectric conversion element in FIG. 1, taken on a plane II as the cross section.
FIG. 3 is a diagram schematically showing how to measure an internal stress in a magnetic body.

DESCRIPTION OF EMBODIMENTS

Hereinafter, embodiments of the present invention will be described with reference to the attached drawings. It should be noted that the present invention is not limited to the following embodiments.

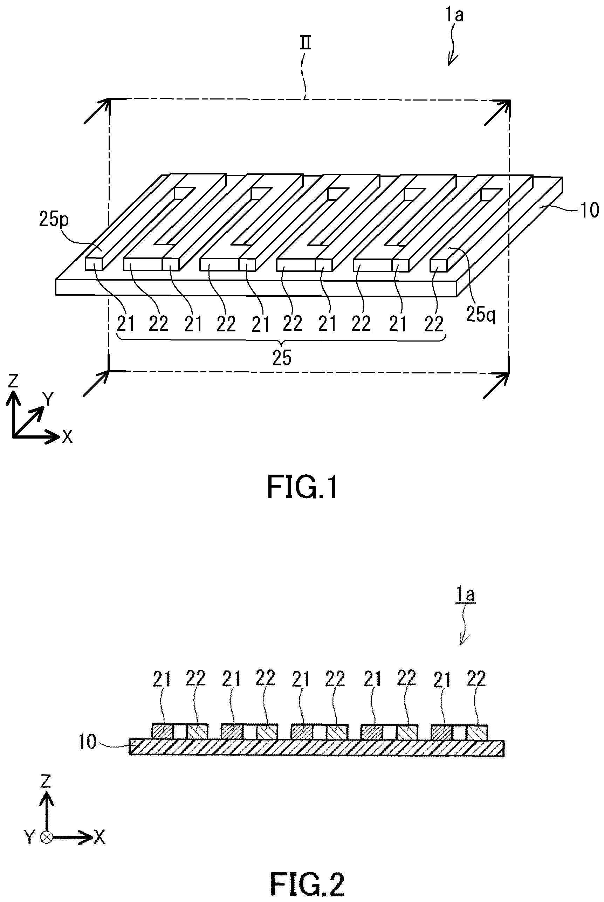

As shown in FIG. 1, a thermoelectric conversion element 1a includes a substrate 10 and magnetic bodies 21. The magnetic bodies 21 are disposed on the substrate 10 and have ferromagnetism or antiferromagnetism. The magnetic bodies 21 have an internal stress of 900 MPa or less. In the present Description, if the value of internal stress is positive, the internal stress is a tensile stress; if the value of internal stress is negative, the internal stress is a compressive stress. By adjusting the internal stress in the magnetic bodies 21 to this range, defects and cracks are less likely to occur in the magnetic bodies 21, for instance, even if the thermoelectric conversion element 1a is placed in a high temperature and high humidity environment. As a result, the thermoelectric conversion element 1a can easily exhibit high durability in a high temperature and high humidity environment. In addition to that, even if a bending stress is applied to the thermoelectric conversion element 1a, defects and cracks are less likely to occur in the magnetic bodies 21. Therefore, the thermoelectric conversion element 1a can easily exhibit high durability even in a state where the thermoelectric conversion element 1a is applied with a bending stress. The internal stress in the magnetic bodies 21 can be measured, for instance, according to the method described in Examples. In FIGs. 1 and 2, an X-axis, a Y-axis and a Z-axis are orthogonal to each other, and the Z-axis direction is a thickness direction of the substrate 10.

In the present Description, the high temperature and high humidity environment is not limited to a specific environment. A high temperature and high humidity environment is, for instance, an environment with a temperature of 60°C to 120°C and a relative humidity of 60% or more. An example of the high temperature and high humidity environment is an environment with a temperature of 85°C and a relative humidity of 85%.

The internal stress in the magnetic bodies 21 may be 800 MPa or less, may be 700 MPa or less, or may be 600 MPa or less. The internal stress in the magnetic bodies 21 is desirably 500 MPa or less. In this case, the thermoelectric conversion element 1a is more likely to exhibit high durability in a high temperature and high humidity environment. In addition to that, even in a state where a bending stress is applied to the thermoelectric conversion element 1a, the thermoelectric conversion element 1a is more likely to exhibit high durability. The internal stress in the magnetic bodies 21 may be 400 MPa or less, may be 300 MPa or less, or may be 200 MPa or less.

More desirably, the internal stress in the magnetic bodies 21 is 100 MPa or less. In this case, the thermoelectric conversion element 1a can easily exhibit higher durability in a high temperature and high humidity environment. In addition to that, even if a bending stress is applied to the thermoelectric conversion element 1a, the thermoelectric conversion element 1a can easily exhibit higher durability. The internal stress in the magnetic bodies 21 may be 0 MPa or less, may be -100 MPa or less, or may be -200 MPa or less.

More desirably, the internal stress in the magnetic bodies 21 is -300 MPa or less. In this case, even if a bending stress is applied to the thermoelectric conversion element 1a, the thermoelectric conversion element 1a can easily exhibit higher durability. The internal stress in the magnetic bodies 21 is, for instance, -2000 MPa or more. The internal stress in the magnetic bodies 21 may be -1500 MPa or more, may be -1000 MPa or more, or may be -500 MPa or more.

As long as the magnetic bodies 21 have an internal stress of 900 MPa or less, the magnetic bodies 21 are not limited to a specific material. The magnetic bodies 21 generate an electromotive force in a direction orthogonal to the thickness direction (Z-axis direction) of the substrate 10, for instance, when a temperature gradient $\nabla T$ occurs in the thickness direction of the substrate 10. As a result, unlike a thermoelectric conversion element that utilizes the Seebeck effect for instance, it is unnecessary for the thermoelectric conversion element 1a to be thick in order to increase the power generated by the temperature gradient in the thermoelectric conversion element 1a. For instance, by increasing the dimension of the magnetic bodies 21 in a specific direction along the principal surface of the substrate 10, the electric power generated by the temperature gradient $\nabla T$ in the thermoelectric conversion element 1a can be increased. Therefore, the thickness of the thermoelectric conversion element 1a can be decreased easily.

The magnetic bodies 21 generate an electromotive force by, for instance, the magnetothermoelectric effect. The magnetothermoelectric effect is, for instance, anomalous Nernst effect or spin Seebeck effect. As a result, even if the thickness of the thermoelectric conversion element 1a is decreased, the electric power generated by the temperature gradient in the thermoelectric conversion element 1a may increase easily.

The magnetic bodies 21 contain, for instance, a substance expressing the anomalous Nernst effect. The substance expressing the anomalous Nernst effect is not limited to a particular substance. The substance expressing the anomalous Nernst effect is, for instance, a magnetic substance having saturation magnetization of $5 \times 10^{-3}$ T or more, or a substance of a band structure with a Weyl point near the Fermi energy. The magnetic bodies 21 contain, for instance, at least one substance selected from the group consisting of (i), (ii), (iii), (iv) and (v) below, as a substance expressing the anomalous Nernst effect.

(i) A stoichiometric substance having a composition represented by $Fe_3X$

(ii) An off-stoichiometric substance having a composition ratio of Fe and X that deviates from that of the substance in (i) above

(iii) A substance in which a part of the Fe site of the substance in (i) above or a part of the Fe site in the substance in (ii) above is substituted by a typical metal element or a transition element other than X

(iv) A substance having a composition represented by $Fe_3M1_{1-x}M2_x$ ($0 < x < 1$), where M1 and M2 are typical elements different from each other

(v) A substance in which a part of the Fe site of the substance in (i) above is substituted by a transition element other than X, and a part of the X site in the substance in (i) above is substituted by a typical metal element other than X

In the substances (i) to (v), X is a typical element or a transition element. X is, for instance, Al, Ga, Ge, Sn, Si, Ti, Zr, Hf, V, Nb, Ta, Cr, Mo, W, Sc, Ni, Mn, or Co. In the above (iv), the combination of M1 and M2 is not limited to a specific combination as long as M1 and M2 are typical elements different from each other. In the above (iv), the combination of M1 and M2 is, for instance, Ga and Al, Si and Al, or Ga and B.

The magnetic bodies 21 may contain $Co_2MnGa$ or $Mn_3Sn$ as a substance expressing the anomalous Nernst effect.

As shown in FIGs. 1 and 2, the magnetic bodies 21 are shaped like rectangular parallelepipeds that are elongated in a specific direction (Y-axis direction) extending along the principal surface of the substrate 10, for instance. The magnetic bodies 21 are magnetized, for instance, in the X-axis negative direction. In a case where a temperature gradient occurs in the thickness direction of the substrate 10 and a heat flow occurs in the Z-axis positive direction, an electromotive force is generated in the positive direction of the Y-axis that is orthogonal to the Z-axis and the X-axis according to the magnetothermoelectric effect. As described above, the dimension of the magnetic bodies 21 in the Y-axis direction is greater than the dimensions of the magnetic bodies 21 in the Z-axis and the X-axis, and thus, the electromotive force generated by the magnetothermoelectric effect tends to increase. As a result, even if the magnetic bodies 21 are not so thick, the electromotive force generated in the thermoelectric conversion element 1a tends to increase.

As shown in FIG. 1, the thermoelectric conversion element 1a includes, for instance, a conductive path 25. The conductive path 25 includes the magnetic bodies 21 and forms a meander pattern. As a result, the length of the conductive path 25 tends to increase, so that the electromotive force generated in the thermoelectric conversion element 1a tends to increase. For instance, by connecting a wiring to one end part 25p and another end part 25q of the conductive path 25, it is possible to extract the electromotive force generated in the thermoelectric conversion element 1a to the outside. Alternatively, heat flow can be generated in the thickness direction of the substrate 10 by applying a voltage between the one end part 25p and the other end part 25q.

As shown in FIG. 1, the conductive path 25 includes a plurality of magnetic bodies 21. These magnetic bodies 21 are disposed, for instance, at predetermined intervals in the X-axis direction and parallel to each other. For instance, the magnetic bodies 21 are disposed at equal intervals in the X-axis direction. The conductive path 25 further includes a plurality of connectors 22, for instance. The connectors 22 electrically connect the magnetic bodies 21 adjacent to each other in the X-axis direction. The connectors 22 electrically connect, for instance, one end part in the Y-axis direction of each magnetic body 21 and the other end part in the Y-axis direction of another magnetic body 21 adjacent to the first-described magnetic body 21 having one end part. According to this structure, a plurality of magnetic bodies 21 are electrically connected in series, whereby the electromotive force generated at the thermoelectric conversion element 1a tends to increase. One end part in the Y-axis direction of each of the plurality of magnetic bodies 21 is located at the end part of the same side in the Y-axis direction of the magnetic bodies 21, and the other end part in the Y-axis direction of each the plurality of magnetic bodies 21 is located at the end part opposite to the one end part in the Y-axis direction of the magnetic bodies 21.

As shown in FIG. 1, connectors 22 are shaped like rectangular parallelepipeds elongated in the Y-axis direction, for instance. As long as the connectors 22 are capable of electrically connecting the magnetic bodies 21 adjacent to each other, the material for forming the connectors 22 is not limited to any particular materials. The connectors 22 may contain a substance that generates an electromotive force by the magnetothermoelectric effect, for instance, and it may have ferromagnetism or antiferromagnetism. In this case, the connectors 22 are magnetized in the X-axis positive direction, for instance. Thereby, in a case where a temperature gradient occurs in the thickness direction of the substrate 10 and a heat flow is caused in the Z-axis positive direction, an electromotive force is generated in the negative direction of the Y-axis orthogonal to the Z-axis and the X-axis. Thereby, the electromotive force generated in the thermoelectric conversion element 1a tends to increase. The connectors 22 may include a non-magnetic material. In this case, the material for forming the connectors 22 is, for instance, a transition element with paramagnetism. The non-magnetic material included in the connectors 22 is, for instance, gold, copper, copper alloy, aluminum, or aluminum alloy. The connectors 22 may be a cured product of an electroconductive paste.

As long as the magnetic bodies 21 have an internal stress of 900 MPa or less, the substrate 10 is not limited to a specific substrate. The substrate 10 has flexibility, for instance. Therefore, it is possible to dispose the thermoelectric conversion element 1a along the curved surface. The substrate 10 has elasticity for instance, therefore when a strip-shaped specimen made of the substrate 10 is wrapped around a cylindrical mandrel with a diameter of 10 cm so that the longitudinal both ends of the specimen will point in the same direction, the specimen can be elastically deformed. Alternatively, the substrate 10 may be a non-flexible material such as a glass substrate.

In a case where the substrate 10 has flexibility, the substrate 10 include at least an organic polymer, for instance. This may facilitate reducing costs for manufacturing the thermoelectric conversion element 1a. Examples of the organic polymer include polyethylene terephthalate (PET), polyethylene naphthalate (PEN), acrylic resin (PMMA), polycarbonate (PC), polyimide (PI), and cycloolefin polymer (COP).

As long as the magnetic bodies 21 have an internal stress of 900 MPa or less, the linear expansion coefficient of the substrate 10 is not limited to a specific value. The substrate 10 has a linear expansion coefficient of $1.0 \times 10^{-5}/°C$ or more, for instance. As a result, when forming the magnetic bodies 21, a compressive stress tends to be applied to the magnetic bodies 21 due to thermal contraction of the substrate 10. As a result, the internal stress in the magnetic bodies 21 can be easily adjusted to the desired range. In the present Description, the linear expansion coefficient indicates an average value in the temperature range of 25°C to 150°C.

The linear expansion coefficient of the substrate 10 may be $1.5 \times 10^{-5}/°C$ or more, may be $2.0 \times 10^{-5}/°C$ or more, may be $2.5 \times 10^{-5}/°C$ or more, may be $3.0 \times 10^{-5}/°C$ or more, may be $4.0 \times 10^{-5}/°C$ or more, may be $5.0 \times 10^{-5}/°C$ or more, may be $6.0 \times 10^{-5}/°C$ or more, may be $7.0 \times 10^{-5}/°C$ or more, or may be $8.0 \times 10^{-5}/°C$ or more. The linear expansion coefficient of the substrate 10 is, for instance, $15 \times 10^{-5}/°C$ or less. Thereby, tensile stress is likely to be applied to the magnetic bodies 21, so that the internal stress in the magnetic bodies 21 can be easily adjusted to a desired range.

As long as the magnetic bodies 21 have an internal stress of 900 MPa or less, the thickness of the substrate 10 is not limited to a specific value. The thickness of the substrate 10 is, for instance, 200 μm or less. This makes it easy to deform the thermoelectric conversion element 1a along a curved surface so that the thermoelectric conversion element 1a is disposed thereon.

The thickness of the substrate 10 may be 190 μm or less, may be 180 μm or less, may be 170 μm or less, or may be 160 μm or less. The thickness of the substrate 10 may be 150 μm or less, may be 140 μm or less, may be 130 μm or less, may be 120 μm or less, or may be 110 μm or less. The thickness of the substrate 10 may be 100 μm or less, may be 90 μm or less, may be 80 μm or less, may be 70 μm or less, or may be 60 μm or less. The thickness of the substrate 10 is, for instance, 10 μm or more. This may facilitate transporting the substrate 10, and the substrate 10 may easily have a desired handling property. The thickness of the substrate 10 may be 20 μm or more, or may be 30 μm or more.

As long as the magnetic bodies 21 have an internal stress of 900 MPa or less, the thickness of the magnetic bodies 21 is not limited to a specific value. The magnetic bodies 21 have, for instance, a thickness of 1000 nm or less. Thereby, use amount of the material for forming the magnetic bodies 21 in the thermoelectric conversion element 1a can be reduced, and the costs for manufacturing the thermoelectric conversion element 1a can be reduced easily. In addition to that, disconnection of the conductive path 25 in the thermoelectric conversion element 1a is less likely to occur.

Thickness of the magnetic bodies 21 may be 750 nm or less, may be 500 nm or less, may be 400 nm or less, may be 300 nm or less, or may be 200 nm or less. The thickness of the magnetic bodies 21 is, for instance, 5 nm or more. Thereby, the thermoelectric conversion element 1a can easily exhibit high durability. The thickness of the magnetic bodies 21 may be 10 nm or more, may be 20 nm or more, may be 30 nm or more, or may be 50 nm or more.

As long as the magnetic bodies 21 have an internal stress of 900 MPa or less, a width as the dimension in the X-axis direction of each magnetic body 21 is not limited to a particular value. The width of each magnetic body 21 is, for instance, 500 μm or less. Thereby, use amount of the material for forming the magnetic bodies 21 in the thermoelectric conversion element 1a can be reduced, and the costs for manufacturing the thermoelectric conversion element 1a can be reduced easily. In addition to that, numbers of the magnetic bodies 21 can be disposed easily in the X-axis direction, whereby the electromotive force generated in the thermoelectric conversion element 1a may easily increase. It is considered that, if the magnetic body is small in width, cracks are more likely to occur in the magnetic body in a high temperature and high humidity environment. Further it is considered that, if the magnetic body is small in width, defects and cracks are more likely to occur in the magnetic body when a bending stress is applied to the thermoelectric conversion element. However, since the magnetic bodies 21 have an internal stress of 900 MPa or less, even in a case where the

width is 500 μm or less, cracks are less likely to occur in the magnetic bodies in a high temperature and high humidity environment. In addition to that, even if a bending stress is applied to the thermoelectric conversion element 1a, defects and cracks are less likely to occur in the magnetic bodies 21.

As described above, the thermoelectric conversion element 1a includes the conductive path 25 for instance, and the conductive path 25 includes the magnetic bodies 21 forming a meander pattern. In this case, a magnetic body 21 has a line width of 500 μm or less in the meander pattern. Even in this case, since the magnetic bodies 21 have an internal stress of 900 MPa or less, cracks are less likely to occur in the magnetic bodies in a high temperature and high humidity environment. In addition to that, even if a bending stress is applied to the thermoelectric conversion element 1a, defects and cracks are less likely to occur in the magnetic bodies 21.

The width of each magnetic body 21 may be 400 μm or less, may be 300 μm or less, may be 200 μm or less, may be 100 μm or less, or may be 50 μm or less. The width of each magnetic body 21 is, for instance, 0.1 μm or more. Thereby, disconnection of the conductive path 25 in the thermoelectric conversion element 1a is less likely to occur, and the thermoelectric conversion element 1a can easily exhibit high durability. The width of each magnetic body 21 may be 0.5 μm or more, may be 1 μm or more, may be 2 μm or more, may be 5 μm or more, may be 10 μm or more, may be 20 μm or more, or may be 30 μm or more.

As long as the connectors 22 can electrically connect the magnetic bodies 21 adjacent to each other, the thickness of the connectors 22 is not limited to a particular value. The thickness of the connectors 22 is, for instance, 1000 nm or less. Thereby, the use amount of the material for forming the connectors 22 can be reduced, and the costs for manufacturing the thermoelectric conversion element 1a can be reduced easily. In addition to that, disconnection of the conductive path 25 is less likely to occur in the thermoelectric conversion element 1a. The thickness of the connectors 22 may be 750 nm or less, may be 500 nm or less, may be 400 nm or less, may be 300 nm or less, may be 200 nm or less, or may be 100 nm or less.

The thickness of the connectors 22 is, for instance, 5 nm or more. Thereby, the thermoelectric conversion element 1a can easily exhibit high durability. The thickness of the connectors 22 may be 10 nm or more, may be 20 nm or more, may be 30 nm or more, or may be 50 nm or more.

As long as the connectors 22 can electrically connect the magnetic bodies 21 adjacent to each other, a width as the minimum dimension in the X-axis direction of each connector 22 is not limited to a particular value. The width of each connector 22 is, for instance, 500 μm or less. Thereby, use amount of the material for forming the connectors 22 in the thermoelectric conversion element 1a can be reduced, and the costs for manufacturing the thermoelectric conversion element 1a can be reduced easily. In addition to that, numbers of magnetic bodies 21 can be disposed easily in the X-axis direction, whereby the electromotive force generated in the thermoelectric conversion element 1a tends to increase.

The width of each connector 22 may be 400 μm or less, may be 300 μm or less, may be 200 μm or less, may be 100 μm or less, or may be 50 μm or less. The width of each connector 22 is, for instance, 0.1 μm or more. Thereby, disconnection of the conductive path 25 in the thermoelectric conversion element 1a is less likely to occur, and the thermoelectric conversion element 1a can easily exhibit high durability. The width of each connector 22 may be 0.5 μm or more, may be 1 μm or more, may be 2 μm or more, may be 5 μm or more, may be 10 μm or more, may be 20 μm or more, or may be 30 μm or more.

An example of the method for manufacturing the thermoelectric conversion element 1a will be explained. First, a thin film of a precursor for the magnetic bodies 21 is formed on one principal surface of the substrate 10 by any method such as sputtering, chemical vapor deposition (CVD), pulsed laser deposition (PLD), ion plating, plating or the like. Next, a photoresist is applied onto the thin film, a photomask is disposed on the thin film and exposed, followed by wet etching. In this manner, linear patterns of the precursor for a plurality of magnetic bodies 21 disposed at predetermined intervals are formed. Next, a thin film of a precursor for the connectors 22 is formed on the principal surface of substrate 10 by any method such as sputtering, CVD, PLD, ion plating, or plating. Next, a photoresist is applied onto the thin film of the precursor for connectors 22, a photomask is disposed on the thin film of the precursor for connectors 22 and exposed, followed by wet etching. Connectors 22 are obtained in this manner, and the linear patterns of the precursor for the magnetic bodies 21 are electrically connected to each other. Next, the precursor for the magnetic bodies 21 is magnetized to form the magnetic bodies 21. In this manner, the thermoelectric conversion element 1a is obtained. As required, the connectors 22 may be formed by magnetizing the precursor for the connectors 22.

By adjusting the requirements for forming the thin film of the precursor of the magnetic bodies 21, the internal stress in the magnetic bodies 21 can be adjusted to the desired range. For instance, when forming the thin film of the precursor of the magnetic bodies 21 by sputtering, the internal stress in the magnetic bodies 21 can be adjusted to the desired range by adjusting the pressure of the atmosphere for sputtering of the substrate 10, the temperature of the substrate 10, the distance between the target and the substrate, and the magnetic flux density.

When forming a thin film of the precursor of the magnetic bodies 21 by sputtering, the pressure of the atmosphere for sputtering the substrate 10 (process pressure) is not limited to a specific value as long as the internal stress in the magnetic bodies 21 is 900 MPa or less. The process pressure is, for instance, 1.0 Pa. Thereby, even in a case where the substrate 10 includes an organic material, the internal stress in the magnetic bodies 21 may be easily adjusted to 900 MPa or less. The process pressure is desirably 0.5 Pa or less, or more desirably, 0.3 Pa or less. The process pressure is, for instance, 0.05 Pa or more. Thereby, even when the target in the sputtering Is a magnetic body, electric discharge is likely to occur, and the thin film of the precursor of the magnetic bodies 21 can be stably formed.

When forming a thin film of the precursor of the magnetic bodies 21 by sputtering, a TS distance, which is the distance between the target and the substrate, is not limited to a specific value as long as the internal stress in the magnetic bodies 21 is 900 MPa or less. The TS distance is, for instance, 120 mm or less. Thereby, even in a case where the substrate 10 includes an organic material, the internal stress in the magnetic bodies 21 can be easily adjusted to 900 MPa or less. The TS distance is preferably 100 mm or less, it may be 80 mm or less, or may be 60 mm or less. The TS distance is, for instance, 40 mm or more. Thereby, even when the target in the sputtering Is a magnetic body, electric discharge is likely to occur, and the thin film of the precursor of the magnetic bodies 21 can be stably formed.

In a case of forming the thin film of the precursor of the magnetic bodies 21 by sputtering, the conditions of the magnetic field are not limited to a specific condition as long as the internal stress in the magnetic bodies 21 is 900 MPa or less. For instance, the magnetic flux density in the sputtering is 150 mT or less. Thereby, even in a case where the substrate 10 includes an organic material, the internal stress in the magnetic bodies 21 can be easily adjusted to 900 MPa or less. The magnetic flux density may be 120 mT or less. The magnetic flux density is, for instance, 30 mT or more. Thereby, even when the target in the sputtering is a magnetic body, electric discharge is likely to occur, and the thin film of the precursor of the magnetic bodies 21 can be stably formed. The magnetic flux density may be 50 mT or more, or may be 70 mT or more.

The thermoelectric conversion element 1a can be provided, for instance, together with a pressure-sensitive adhesive layer. In this case, the substrate 10 is disposed between the magnetic bodies 21 and the pressure-sensitive adhesive layer in the thickness direction of the substrate 10. Thereby, it is possible to attach the thermoelectric conversion element 1a to an article by pressing the pressure-sensitive adhesive layer onto the article.

The pressure-sensitive adhesive layer includes, for instance, a rubber-based pressure-sensitive adhesive, an acrylic pressure-sensitive adhesive, a silicone-based pressure-sensitive adhesive, or a urethane-based pressure-sensitive adhesive. The thermoelectric conversion element 1a may be provided together with a pressure-sensitive adhesive layer and a separator. In this case, the separator covers the pressure-sensitive adhesive layer. Typically, the separator is a film that can maintain the adhesiveness of the pressure-sensitive adhesive layer while covering the layer, and it can be peeled off easily from the pressure-sensitive adhesive layer. The separator is, for instance, a film made of a polyester resin like PET By peeling the separator off, the pressure-sensitive adhesive layer is exposed and the thermoelectric conversion element 1a can be adhered to an article.

EXAMPLES

Hereinafter, the present invention will be described in detail by referring to Examples. It should be noted that the present invention is not limited to the following Examples. First, evaluation methods regarding Examples and Comparative Examples will be explained.

[Measurement of internal stress]

By using an X-ray diffractometer RINT2200 manufactured by Rigaku Corporation, a sample was irradiated with a Cu-K$\alpha$ ray from a light source of 40 kV and 40 mA through a parallel beam optical system, thereby evaluating the internal stress in the magnetic body in each Example and each Comparative Example in accordance with the principle of a $\sin^2\psi$ method. The Cu-K$\alpha$ ray had a wavelength $\lambda$ of 0.1541 nm. The $\sin^2\psi$ method is a method for determining the internal stress in a polycrystalline thin film from the dependence of the crystal lattice strain with respect to the angle ($\psi$) of the thin film. Using the aforementioned X-ray diffractometer, a diffraction intensity was measured every 0.02° in the range of $2\theta = 40°$ to $50°$ through a $\theta/2\theta$ scan measurement. The integration time at each measurement point was set to 100 seconds. The crystal lattice interplanar distance d of the magnetic body at each measurement angle ($\psi$) was calculated from the peak angle $2\theta$ of the obtained X-ray diffraction and the wavelength $\lambda$ of the X-ray irradiated from the light source, and the crystal lattice strain $\varepsilon$ was calculated from the crystal lattice interplanar distance d, based on the relationship between the following Equations (1) and (2). The $\lambda$ is the wavelength of X-ray (Cu-K$\alpha$ ray) emitted from the light source, and $\lambda$ = 0.1541 nm. Here, $d_0$ is the lattice interplanar distance of the magnetic body in a stress-free state, and $d_0$ = 0.0206 nm.

$$2d\sin\theta = \lambda \qquad \text{Equation (1)}$$

$$\varepsilon = (d - d_0)/d_0 \qquad \text{Equation (2)}$$

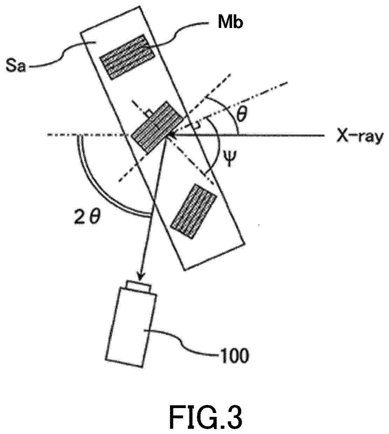

As shown in FIG. 3, the aforementioned X-ray diffraction measurement was performed for each case where the angle ($\psi$) between the normal to the principal surface of magnetic body sample Sa and the normal to the crystal plane of magnetic body Mb was 45°, 52°, 60°, 70° or 90°, thereby calculating the crystal lattice strain $\varepsilon$ at each angle ($\psi$). Thereafter, the residual stress (internal stress) $\sigma$ in the in-plane direction of the magnetic body was calculated from a slope of a straight line plotting the relationship between $\sin^2\psi$ and crystal lattice strain $\varepsilon$ from Equation (3) below. The results are shown in Table 1. For the internal stress in Table 1, a positive value indicates a tensile stress and a negative value indicates a compressive stress.

$$\varepsilon = \{(1 + v)/E\} \, \sigma \sin^2\Psi - (2v/E) \, \sigma \qquad \text{Equation (3)}$$

In the above Equation (3), E is a Young's modulus (210 GPa) of the magnetic body, and v is a Poisson's ratio (0.3) of the magnetic body. In the figure, a detector 100 detects an X-ray diffraction.

[High temperature and high humidity environment test]

A durability test was performed by maintaining the environment of the thermoelectric conversion element according to each Example and each Comparative Example in a condition of a temperature of 85°C and a relative humidity of 85% for 24 hours. The electrical resistance value $R_0$ of the meander pattern in the thermoelectric conversion element before the durability test and the electrical resistance value Rt of the meander pattern in the thermoelectric conversion element after the durability test were measured, and the value of $100 \times (Rt - R_0)/R_0$ was determined as the resistance change rate. The results are shown in Table 1.

[Flexibility property evaluation]

A strip-shaped specimen was made of the thermoelectric conversion element according to each Example and each Comparative Example. The specimen was wrapped around a horizontally-fixed cylindrical mandrel having the following diameter, and a 100g weight was attached to the both ends of the specimen to apply a load to the specimen. Afterwards, it was checked whether there was any disconnection in the meander pattern in the specimen. It was determined that a disconnection in the meander pattern occurred when the electrical resistance value of the meander pattern became 1.5 times or more of the initial value. In each Example and each Comparative Example, the mandrel to be used were selected in descending order of mandrel diameter, and the maximum value of the mandrel diameter at which the disconnection of the meander pattern occurred was determined. The results are shown in Table 1.

(Diameter of mandrel)

21.5 mm, 20 mm, 18.5 mm, 17 mm, 15.5 mm, 14 mm, 12.5 mm, 11 mm, 9.5 mm, 8 mm, 6.5 mm, and 5 mm

The thermoelectric conversion element according to each Example and each Comparative Example was fixed between a pair of Cu plates with dimensions of 30 mm, 30 mm, and 5 mm, using silicone grease KS609 manufactured by Shin-Etsu Chemical Co., Ltd., thereby producing a sample for thermoelectric property evaluation. This sample was placed on a cool plate SCP-125 supplied by AS ONE Corporation. A film heater manufactured by Shinwa Rules Co., Ltd. was fixed on the upper Cu plate with a double-sided tape No. 5000NS manufactured by Nitto Denko Corporation. This heater had dimensions of 30 mm square and an electrical resistance value of 20 $\Omega$. While the temperature of the cool plate was maintained at 25°C, the film heater was made generate heat under a constant voltage control of 10 V, and the amount of heat output from the film heater was adjusted to 0.52 W/cm$^2$. At this time, the electromotive force generated in the thermoelectric conversion element was measured using a data logger, which was then divided by the area of the thermoelectric conversion element so as to read the value of electromotive force per unit area in a steady state. The results are shown in Table 1.

<Example 1>

A thin film having a thickness of 96 nm was formed on a polyethylene terephthalate (PET) film having a thickness of 50 $\mu$m by DC magnetron sputtering, using a target material containing Fe and Ga. In this target material, the atomic ratio of the Fe content to the Ga content was in a relationship of 3:1. In the DC magnetron sputtering, the distance between the target material and the PET film was adjusted to 75 mm. Further in the DC magnetron sputtering, a magnet with a magnetic flux density of 100 mT was used, and an argon gas was fed as a process gas at a pressure of 0.1 Pa. Furthermore, the temperature of the PET film was adjusted to 130°C. The PET film had a linear expansion coefficient of $7.0 \times 10^{-5}$/°C. A photoresist was applied onto the thin film, a photomask was disposed on the thin film and exposed, followed by wet etching. Thereby, 98 FeGa-containing linear patterns aligned at predetermined intervals were formed. The width of each FeGa-containing linear pattern was 100 $\mu$m, the length of each FeGa linear pattern was 15 mm, and the total length of the FeGa linear patterns was 147 cm. After that, a Cu thin film having a thickness of 100 nm was formed by DC magnetron sputtering using a Cu-containing target material. A photoresist was applied onto the Cu thin film, a photomask was disposed on the Cu thin film and exposed, followed by wet etching. In this manner, a Cu-containing linear pattern having a width of 40 $\mu$m was formed. A pair of adjacent FeGa-containing linear patterns were electrically connected by the Cu-containing linear pattern, thereby forming a conductive path of a meander pattern. Using an electromagnet with a central magnetic flux density of 0.5 T, the FeGa-containing linear pattern was magnetized in a direction parallel to the plane of the PET film and orthogonal to the length direction of the FeGa-containing linear pattern, whereby a magnetic body was formed. The thickness of the magnetic body was 96 nm. In this way, the thermoelectric conversion element according to Example 1 was obtained. This thermoelectric conversion element generated an electromotive force by the anomalous Nernst effect.

<Example 2>

A thermoelectric conversion element according to Example 2 was obtained in the same manner as in Example 1 except that the argon gas was fed as the process gas at a pressure of 0.2 Pa. The magnetic body in the thermoelectric conversion element according to Example 2 had a thickness of 96 nm.

<Example 3>

A thermoelectric conversion element according to Example 3 was obtained in the same manner as in Example 1 except that the argon gas was fed as the process gas at a pressure of 0.9 Pa. The magnetic body in the thermoelectric conversion element according to Example 3 had a thickness of 89 nm.

<Example 4>

A thermoelectric conversion element according to Example 4 was obtained in the same manner as in Example 1 except that a polyimide (PI) film having a thickness of 50 $\mu$m was used instead of the PET film and the temperature of the PI film during the DC magnetron sputtering was adjusted to 25°C. The magnetic body in the thermoelectric conversion element according to Example 4 had a thickness of 100 nm.

<Example 5>

A thermoelectric conversion element according to Example 5 was obtained in the same manner as in Example 1 except that the temperature of the PET film was adjusted to 100°C and the argon gas was fed as the process gas at a pressure of 0.2 Pa during the DC magnetron sputtering. The magnetic body in the thermoelectric conversion element according to Example 5 had a thickness of 96 nm.

<Example 6>

A thermoelectric conversion element according to Example 6 was obtained in the same manner as in Example 1 except that the temperature of the PET film was adjusted to 50°C and the argon gas was fed as the process gas at a pressure of 0.2 Pa during the DC magnetron sputtering. The magnetic body in the thermoelectric conversion element according to Example 6 had a thickness of 96 nm.

<Example 7>

A thermoelectric conversion element according to Example 7 was obtained in the same manner as in Example 1 except that the temperature of the PET film was adjusted to 25°C during the DC magnetron sputtering. The magnetic body in the thermoelectric conversion element according to Example 7 had a thickness of 96 nm.

<Example 8>

A thermoelectric conversion element according to Example 8 was obtained in the same manner as in Example 1 except that the requirements for the wet etching were adjusted so that the width of each FeGa-containing linear pattern would be 50 $\mu$m. The magnetic body in the thermoelectric conversion element according to Example 8 had a thickness of 96 nm.

<Example 9>

A thermoelectric conversion element according to Example 9 was obtained in the same manner as in Example 1 except that the requirements for the wet etching were adjusted so that the width of each FeGa-containing linear pattern would be 200 $\mu$m. The magnetic body in the thermoelectric conversion element according to Example 9 had a thickness of 96 nm.

<Example 10>

A thermoelectric conversion element according to Example 10 was obtained in the same manner as in Example 1 except that the requirements for the wet etching were adjusted so that the width of each FeGa-containing linear pattern would be 300 $\mu$m. The magnetic body in the thermoelectric conversion element according to Example 10 had a thickness of 96 nm.

<Example 11>

A thermoelectric conversion element according to Example 11 was obtained in the same manner as in Example 1 except that the requirements for the wet etching were adjusted so that the width of each FeGa-containing linear pattern would be 400 $\mu$m. The magnetic body in the thermoelectric conversion element according to Example 11 had a thickness of 96 nm.

<Comparative Example 1>

A thermoelectric conversion element according to Comparative Example 1 was obtained in the same manner as in Example 1 except that the argon gas was fed as the process gas at a pressure of 1.6 Pa. The magnetic body in the thermoelectric conversion element according to Comparative Example 1 had a thickness of 85 nm.

<Comparative Example 2>

A thermoelectric conversion element according to Comparative Example 2 was obtained in the same manner as in Example 1 except that the argon gas was fed as the process gas at a pressure of 1.6 Pa during the DC magnetron sputtering, and that the requirements for the wet etching were adjusted so that the width of each FeGa-containing linear pattern would be 1000 $\mu$m. The magnetic body in the thermoelectric conversion element according to Comparative Example 2 had a thickness of 85 nm. This thermoelectric conversion element did not exhibit an electromotive force based on the anomalous Nernst effect.

As shown in Table 1, the internal stress in the magnetic body of the thermoelectric conversion element according to each Example was 900 MPa or less, while the internal stress in the magnetic body of the thermoelectric conversion element according to Comparative Example exceeded 900 MPa. The resistance change rate in the durability test for the thermoelectric conversion element according to each Example was much lower than the resistance change rate in the durability test for the thermoelectric conversion element according to Comparative Example. Therefore, it has been suggested that, by adjusting the internal stress of the magnetic body to 900 MPa or less, the thermoelectric conversion element can exhibit high durability in a high temperature and high humidity environment.

As shown in Table 1, the maximum value of the mandrel diameter at which disconnection occurs in the flexibility property evaluation for each Example was smaller than the maximum value of the mandrel diameter at which disconnection occurs in the flexibility property evaluation for Comparative Example. It has been suggested that, by adjusting the internal stress in the magnetic body to 900 MPa or less, the thermoelectric conversion element is capable of exhibiting favorable durability during bending.

As shown in Table 1, according to the measurement results for the thermoelectromotive force of each thermoelectric conversion element, the thermoelectromotive force of the thermoelectric conversion element according to Example was greater than the thermoelectromotive force of the thermoelectric conversion element according to Comparative Example 2. It has been shown that, since the internal stress of the magnetic body is adjusted to 900 MPa or less and the line width of the magnetic body is 500 $\mu$m or less, an electromotive force based on the anomalous Nernst effect can be expressed while exhibiting favorable durability during bending.

[Table 1]

| | Substrate | | | Feed pressure of argon gas in DC magnetron sputtering [Pa] | Substrate temperature in DC magnetron sputtering [°C] |
|---|---|---|---|---|---|
| | Material | Thickness [μm] | Linear expansion coefficient [×10<sup>-5</sup>/°C] | | |
| Example 1 | PET | 50 | 7.0 | 0.1 | 130 |
| Example 2 | PET | 50 | 7.0 | 0.2 | 130 |
| Example 3 | PET | 50 | 7.0 | 0.9 | 130 |
| Example 4 | PI | 50 | 1.6 | 0.2 | 25 |
| Example 5 | PET | 50 | 7.0 | 0.2 | 100 |
| Example 6 | PET | 50 | 7.0 | 0.2 | 50 |
| Example 7 | PET | 50 | 7.0 | 0.1 | 25 |
| Example 8 | PET | 50 | 7.0 | 0.1 | 130 |
| Example 9 | PET | 50 | 7.0 | 0.1 | 130 |
| Example 10 | PET | 50 | 7.0 | 0.1 | 130 |
| Example 11 | PET | 50 | 7.0 | 0.1 | 130 |
| Comparative Example 1 | PET | 50 | 7.0 | 1.6 | 130 |
| Comparative Example 2 | PET | 50 | 7.0 | 1.6 | 130 |

Table 1] Continued

| | Magnetic body thickness [nm] | Magnetic body line width [μm] | Internal stress in magnetic body [MPa] | High temperature and high humidity environment test | Flexibility property evaluation | Thermoelectromotive force per cm$^2$ in steady state [mV/cm$^2$] |
|---|---|---|---|---|---|---|
| | | | | Resistance change rate [%] | Maximum mandrel diameter at which disconnection occurs [mm] | |
| Example 1 | 96 | 100 | -331 | -2.7 | No disconnection | 0.65 |
| Example 2 | 96 | 100 | 74 | -0.6 | 6.5 | 0.73 |
| Example 3 | 89 | 100 | 473 | 15.4 | 17 | 0.67 |
| Example 4 | 100 | 100 | 750 | 0.5 | 8 | 0.62 |
| Example 5 | 96 | 100 | 102 | 0.4 | 5 | 0.68 |
| Example 6 | 96 | 100 | 265 | 4.2 | 6.5 | 0.66 |
| Example 7 | 96 | 100 | 600 | 16.7 | 17 | 0.66 |
| Example 8 | 96 | 50 | -431 | -2.7 | 5 | 0.95 |
| Example 9 | 96 | 200 | -378 | -1.8 | No disconnection | 0.42 |

(continued)

| | Magnetic body thickness [nm] | Magnetic body line width [μm] | Internal stress in magnetic body [MPa] | High temperature and high humidity environment test | Flexibility property evaluation | Thermoelectromotive force per cm$^2$ in steady state [mV/cm$^2$] |
| --- | --- | --- | --- | --- | --- | --- |
| | | | | Resistance change rate [%] | Maximum mandrel diameter at which disconnection occurs [mm] | |
| Example 10 | 96 | 300 | -194 | -1.3 | No disconnection | 0.34 |
| Example 11 | 96 | 400 | -159 | -0.9 | No disconnection | 0.27 |
| Comparative Example 1 | 85 | 100 | 905 | ≥100 | 21.5 | 0.59 |
| Comparative Example 2 | 85 | 1000 | 902 | 12 | 10 | 0.06 |

A first aspect of the present invention provides a thermoelectric conversion element including:

a substrate; and
a magnetic body disposed on the substrate and having ferromagnetism or antiferromagnetism,
wherein the magnetic body has an internal stress of 900 MPa or less.

A second aspect of the present invention provides a thermoelectric conversion element according to the first aspect, wherein the substrate of the thermoelectric conversion element has flexibility.

A third aspect of the present invention provides a thermoelectric conversion element according to the second aspect, wherein the substrate of the thermoelectric conversion element includes at least an organic polymer.

A fourth aspect of the present invention provides a thermoelectric conversion element according to any one of the first to third aspects, wherein the substrate of the thermoelectric conversion element has a linear expansion coefficient of $1.0 \times 10^{-5}$/°C or more.

A fifth aspect of the present invention provides a thermoelectric conversion element according to any one of the first to fourth aspects, wherein the substrate of the thermoelectric conversion element has a thickness of 200 μm or less.

A sixth aspect of the present invention provides a thermoelectric conversion element according to any one of the first to fifth aspects, wherein the magnetic body of the thermoelectric conversion element has a thickness of 1000 nm or less.

A seventh aspect of the present invention provides a thermoelectric conversion element according to any one of the first to sixth aspects, wherein the magnetic body of the thermoelectric conversion element has a width of 500 μm or less.

An eighth aspect of the present invention provides a thermoelectric conversion element according to any one of the first to seventh aspects, wherein the magnetic body of the thermoelectric conversion element generates an electromotive force in a direction orthogonal to a thickness direction of the substrate when a temperature gradient occurs in the thickness direction of the substrate.

A ninth aspect of the present invention provides a thermoelectric conversion element according to any one of the first to eighth aspects, wherein the magnetic body of the thermoelectric conversion element is capable of generating an electromotive force by a magnetothermoelectric effect.

A tenth aspect of the present invention provides a thermoelectric conversion element according to any one of the first to ninth aspects, the thermoelectric conversion element includes a conductive path including the magnetic body and forming a meander pattern.

An eleventh aspect of the present invention provides a thermoelectric conversion element according to the tenth aspect, wherein the magnetic body of the thermoelectric conversion element has a line width of 500 μm or less in the meander pattern.

**Claims**

1.  A thermoelectric conversion element comprising:

    a substrate; and
    a magnetic body disposed on the substrate and having ferromagnetism or antiferromagnetism,
    wherein the magnetic body has an internal stress of 900 MPa or less.

2.  The thermoelectric conversion element according to claim 1, wherein the substrate has flexibility.

3.  The thermoelectric conversion element according to claim 2, wherein the substrate comprises at least an organic polymer.

4.  The thermoelectric conversion element according to claim 1, wherein the substrate has a linear expansion coefficient of $1.0 \times 10^{-5}/°C$ or more.

5.  The thermoelectric conversion element according to claim 1, wherein the substrate has a thickness of 200 $\mu$m or less.

6.  The thermoelectric conversion element according to claim 1, wherein the magnetic body has a thickness of 1000 nm or less.

7.  The thermoelectric conversion element according to claim 1, wherein the magnetic body has a width of 500 $\mu$m or less.

8.  The thermoelectric conversion element according to claim 1, wherein the magnetic body generates an electromotive force in a direction orthogonal to a thickness direction of the substrate when a temperature gradient occurs in the thickness direction of the substrate.

9.  The thermoelectric conversion element according to claim 1, wherein the magnetic body is capable of generating an electromotive force by an magnetothermoelectric effect.

10. The thermoelectric conversion element according to claim 1, comprising a conductive path comprising the magnetic body, the conductive path forming a meander pattern.

11. The thermoelectric conversion element according to claim 10, wherein the magnetic body has a line width of 500 $\mu$m or less in the meander pattern.

FIG.1

FIG.2

FIG.3

## INTERNATIONAL SEARCH REPORT

| International application No. |
|---|
| **PCT/JP2022/029863** |

### A. CLASSIFICATION OF SUBJECT MATTER

*H01L 37/04*(2006.01)i; *H02N 11/00*(2006.01)i
FI:   H01L37/04; H02N11/00

According to International Patent Classification (IPC) or to both national classification and IPC

### B. FIELDS SEARCHED

Minimum documentation searched (classification system followed by classification symbols)

H01L37/04; H02N11/00

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| Y | WO 2020/218613 A1 (THE UNIVERSITY OF TOKYO) 29 October 2020 (2020-10-29) paragraphs [0013]-[0040], [0095]-[0096], [0100]-[0101], fig. 1-7 | 1-11 |
| Y | JP 2013-508983 A (DESTRON FEARING CORPORATION) 07 March 2013 (2013-03-07) paragraphs [0017]-[0019], [0026]-[0028], [0041], fig. 1-2 | 1-11 |

☐ Further documents are listed in the continuation of Box C.      ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **30 September 2022** | **11 October 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

**INTERNATIONAL SEARCH REPORT**
**Information on patent family members**

International application No.

**PCT/JP2022/029863**

| Patent document cited in search report | | | Publication date (day/month/year) | Patent family member(s) | | | Publication date (day/month/year) |
|---|---|---|---|---|---|---|---|
| WO | 2020/218613 | A1 | 29 October 2020 | EP | 3961733 | A1 | |
| | | | | paragraphs [0013]-[0040], [0095]-[0096], [0100]-[0101], fig. 1-7 | | | |
| | | | | CN | 113728447 | A | |
| JP | 2013-508983 | A | 07 March 2013 | US | 2011/0094556 | A1 | |
| | | | | paragraphs [0018]-[0020], [0038]-[0040], [0053], fig. 1-2 | | | |
| | | | | WO | 2011/050203 | A1 | |
| | | | | EP | 2491602 | A1 | |
| | | | | CN | 102612762 | A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2014072256 A